# EUROPEAN PATENT APPLICATION

(11) **EP 4 354 152 A1**
(43) Date of publication of application: **17.04.2024**
(21) Application number: 22201597.6
(22) Date of filing: 14.10.2022
(51) Int. Cl.: G01R 1/04, G01R 31/28, G01R 35/00

(54) **POWER CALIBRATION ADAPTER, MEASUREMENT APPLICATION SYSTEM, METHOD**

(71) Applicant: Rohde & Schwarz GmbH & Co. KG, 81671 München (DE)
(72) Inventor: RIEDMANN, Nico, 81667 München (DE); BURGER, Anna Katharina, 83137 Schonstett (DE); FRIESINGER, Maximilian, 81669 München (DE)
(74) Representative: Kehl, Ascherl, Liebhoff & Ettmayr Patentanwälte Partnerschaft mbB

(57) **Abstract**

The present disclosure provides a power calibration adapter for wafer probers, the power calibration adapter comprising at least one first landing pad, for releasably contacting a wafer prober tip of the wafer prober, and a power meter interface for each one of the first landing pads that is coupled to the at least one first landing pad and that is configured to couple the at least one first landing pad to a power measurement device. Further, the present disclosure provides a respective measurement application system and a respective method.

## Description

### TECHNICAL FIELD

The disclosure relates to a power calibration adapter, a measurement application system and a respective method.

### BACKGROUND

Although applicable to any type of measurement application device, the present disclosure will mainly be described in conjunction with wafer probers.

The development and, especially manufacturing, of integrated circuits requires extensive testing during the production process of the integrated circuits.

To this end, so called wafer probers may be used to test the integrated circuits in the respective wafer. However, the wafer probers need to be calibrated in a complex calibration process in order to provide useful measurement results.

Accordingly, there is a need for providing a simple calibration for wafer probers.

### SUMMARY

The above stated problem is solved by the features of the independent claims. It is understood, that independent claims of a claim category may be formed in analogy to the dependent claims of another claim category.

Accordingly, it is provided:
A power calibration adapter for wafer probers, the power calibration adapter comprising at least one first landing pad, for releasably contacting a wafer prober tip of the wafer prober, and a power meter interface for each one of the first landing pads that is coupled to the at least one first landing pad and that is configured to couple the at least one first landing pad to a power measurement device.

Further, it is provided:
A measurement application system, comprising a power calibration adapter according to any one of the preceding claims, and a power measurement device coupled to at least one power meter interface of the power calibration adapter, and configured to determine a signal power of a signal that is applied to a wafer prober tip of a wafer prober while the wafer prober tip is contacting a respective first landing pad of the power calibration adapter.

Further, it is provided:
A method for calibrating a wafer prober, the method comprising contacting with each one of at least one wafer prober tip of the wafer prober at least one second landing pad of a power calibration adapter, especially a power calibration adapter according to the present disclosure, and especially three different second landing pads coupled to an open calibration standard, a short calibration standard, and a match calibration standard, determining calibration parameters of the at least one wafer prober tip while the wafer prober tip contacts the at least one second landing pad, performing a 1-port calibration for the at least one wafer prober tip based on the determined calibration parameters, contacting with the at least one wafer prober tip a first landing pad, and performing a power calibration for the at least one wafer prober tip.

The present disclosure is based on the finding that recalibrating of wafer probers is usually a cumbersome task that stops the respective production machine for an important amount of time.

The present disclosure aims to provide a possibility to quickly recalibrate wafer probers.

A wafer prober is a test equipment or device that may be used to test integrated circuits, while the integrated circuit is still comprised by a respective wafer i.e., without separating the single integrated circuits from the wafer. Such a wafer prober may comprise a plurality of wafer probers, each with at least one wafer prober tip.

When performing a test of an integrated circuit, the wafer prober is moved to the respective position over the wafer and the wafer prober tip is lowered onto respective probing pads or probing points in the integrated circuit that is to be tested. One of the possible tests that may be performed on such an integrated circuit is a power measurement. Such a power measurement, however, requires a power calibration of the wafer prober tip.

When performing a test or measurement with a wafer prober tip, the reference plane for calibration of the measurement or test setup is not provided by a cable or connector that may be connected to a device under test. Instead, the reference plane is moved to the front of the wafer prober tip.

A cable or connector may easily be taken into account during a measurement by performing a known calibration with respective calibration standards connected to the cable or connector prior to performing a measurement.

With the reference plane being shifted to the front of the wafer prober tip, such known calibrations with respective calibration standards are not applicable. To overcome these limitations, in traditional measurement applications, the calibration is performed for the measurement setup without the wafer prober. The influence of the wafer prober is then taken into account based on standard S-Parameters provided for the respective wafer prober, for example, by the manufacturer of the wafer prober.

However, such an approach cannot account for time variant parameters of the wafer prober. Such time variant parameters may, for example, be caused by degradation or wear of the prober tip over time, and a change in ambient temperature or humidity in the test facility.

To overcome these limitations, the present disclosure provides the power calibration adapter for calibrating wafer probers, especially for calibrating the wafer prober tips of the wafer probers.

The power calibration adapter comprises at least one first landing pad that may releasably contact a wafer prober tip and is coupled to a power meter interface. It is understood, that a power meter interface may be provided for each one of the first landing pads. A power meter interface for each one of the first landing pads may also be provided by providing less power meter interfaces than first landing pads, and providing a respective controllable switching or coupling matrix that may controllably couple first landing pads with respective power meter interfaces.

The expression "releasably contact" a wafer prober tip is to be understood as encompassing any type of electrical contact, especially, the wafer prober tip simply being placed on or laid down on the respective first landing pad.

The term landing pad in the context of this disclosure may generally refer to a single electrical contacting area. As alternative, the term landing pad may refer to multiple electrical contacting areas that may each accommodate a wafer prober tip of a single wafer prober. For example, such a landing pad may comprise a signal contacting area for contacting a signal measurement wafer prober tip of the wafer prober, and at least one, especially two or more, ground contacting areas for contacting ground wafer prober tips of the wafer prober. Such ground contacting areas will usually be provided on two opposite sides of the signal contacting area.

It is understood, that the power calibration adapter may comprise any number of first landing pads, and that the number of first landing pads may be adapted to the respective test or measurement application.

By providing an interface to the first landing pads via the power meter interfaces, calibration measurements may be performed exactly where the reference plane resides during the testing of integrated circuits i.e., the respective wafer prober tip. The power meter interface may in embodiments comprise a coaxial-based interface, like a BNC connector, or a waveguide interface.

In a measurement application system according to the present disclosure, the power meter interface may be coupled to a power measurement device that is configured to measure a signal power applied to a wafer prober tip via the power calibration adapter while the wafer prober tip contacts a respective first landing pad of the power calibration adapter. The measured signal power may then be used during measurements performed with the wafer prober tip on a device under test, to correct the measurements accordingly e.g., to perform power calibrations.

In embodiments, a measurement device may be coupled to the wafer prober tip of the wafer prober and may correct measurement signals received from the wafer prober while performing measurements on a device under test based on the determined signal power.

With the power calibration adapter a wafer prober, especially the wafer prober tips, may be calibrated whenever needed in a measurement application. Such a measurement may be performed in a fully automatic manner, for example, in a wafer production facility. In addition, the calibration does not depend on standard S-Parameters provided for the wafer prober, but on actual measurements performed on the wafer prober tip.

It is, therefore, possible with the power calibration adapter and the measurement application system to perform a real power calibration whenever required e.g., for taking into account wear of the wafer prober tip, without relying on inaccurate S-Parameters.

Since the wafer prober tip is directly contacted, the size of the power calibration adapter will be very small, for example, similar to the size of the wafer or integrated circuit that is tested. The power calibration adapter may, therefore, easily be moved to the positions of the wafer prober tips, or the wafer prober tips may be moved to the power calibration adapter in the measurement application. The wafer probers may, consequently, be calibrated in the measurement application without removing the wafer prober tips from the measurement application.

In embodiments, the wafer probers may be positioned within the measurement application at fixed positions. In such applications, the power calibration adapter may be moved to the respective positions to calibrate the wafer probers.

Further embodiments of the present disclosure are subject of the further dependent claims and of the following description, referring to the drawings.

In the following, the dependent claims referring directly or indirectly to claim 1 are described in more detail. For the avoidance of doubt, the features of the dependent claims relating to the power calibration adapter can be combined in all variations with each other and the disclosure of the description is not limited to the claim dependencies as specified in the claim set. The same applies to the measurement application system.

In an embodiment, which can be combined with all other embodiments of the power calibration adapter mentioned above or below, the power calibration adapter may further comprise at least one second landing pad and a calibration standard coupled to each one of the second landing pads.

The second landing pads serve for performing additional measurements with the power calibration adapter. It is understood, that any calibration standard may be used that allows performing a further calibration measurement of the wafer prober tip. In embodiments, multiple second landing pads may be provided, each with a respective calibration standard. The second landing pads, as explained above, may comprise a single electrical contacting area, or multiple electrical contacting areas.

Different calibration standards with well-defined termination or connections serve to perform different calibration measurements for wafer prober tips. Each measurement may be used to determine one of multiple error terms that may be required in a respective error model that may be implemented in a measurement device, like a vector network analyzer. With the help of the determined error terms and respective error models, it is then possible to eliminate effects that may be introduced e.g., by connectors, couplings, and landing pads, into the measurement.

With the second landing pads it is possible to determine not only parameters that are required for power calibration of the wafer prober tip. Instead, further parameters or error terms may be determined that allow performing further calibrations or error compensations in the measurement application system.

In a further embodiment, which can be combined with all other embodiments of the power calibration adapter mentioned above or below, the calibration standard may comprise at least one of an open calibration standard, a short calibration standard, and a match calibration standard.

The three calibration standards open, short, and match are calibration standards that on a smith diagram result in measurements with maximum distance.

The open calibration standard may, for example, be implemented by ending the electrical signal path with the respective second landing pad, if only one electrical area is present. If a signal contacting area and one or more ground contacting areas are present, no electrical connection may be provided between these areas in order to implement the open calibration standard.

The short calibration standard may, for example, be implemented by coupling the electrical signal path with the respective second landing pad directly to ground, if only one electrical area is present. If a signal contacting area and one or more ground contacting areas are present, a direct, no- or low-resistance electrical connection may be provided between these areas in order to implement the short calibration standard.

The match calibration standard may, for example, be implemented by coupling the electrical signal path with the respective second landing pad to ground via a capacitor of a predefined capacitance, if only one electrical area is present. If a signal contacting area and one or more ground contacting areas are present, an electrical connection with a predefined impedance may be provided between the signal contacting area and each one of the ground contacting areas in order to implement the match calibration standard.

In another embodiment, which can be combined with all other embodiments of the power calibration adapter mentioned above or below, the power calibration adapter may comprise at least two of the second landing pads, wherein a single one of the calibration standards may be coupled to the at least two second landing pads, the calibration standard comprising at least one of a through calibration standard, and a line calibration standard.

The calibration standards that are presented above i.e., an open calibration standard, a short calibration standard, and a match calibration standard, are calibration standards for performing 1-port measurements that are coupled to a single one of the second landing pads. In contrast, a through calibration standard and a line calibration standard allow performing 2-port measurements with two wafer probers, and are usually coupled to two of the second landing pads.

The through calibration standard and the line calibration standard may be implemented as respective conductive lines between the contacting areas. Of course, ground contacting areas may also be provided.

The line calibration standard may be provided as a λ/4 line for a respective frequency range. Since such a line will only perform as λ/4 line within a specific frequency range, multiple such line calibration standards may be provided, each one adapted for a specific frequency range.

In another further embodiment, which can be combined with all other embodiments of the power calibration adapter mentioned above or below, the power calibration adapter may further comprise at least one carrier substrate, wherein at least one first landing pad is arranged on each one of the carrier substrates. If present, the at least one second landing pad may also be provided either on a carrier substrate together with the first landing pads, or on at least one dedicated carrier substrate for the second landing pads.

The carrier substrate may, for example, be provided as a ceramic substrate, like aluminum nitride or aluminum oxide substrate, as a quartz substrate, like glass, as a diamond or sapphire substrate, or as a printed circuit board material substrate. The printed circuit board material substrate may especially be used for lower frequency applications.

Using a carrier substrate allows implementing the required electrical structures, like the first landing pads, the second landing pads, and calibration standards easily using known manufacturing processes for processing such carrier substrates.

In another embodiment, which can be combined with all other embodiments of the power calibration adapter mentioned above or below, the power calibration adapter may further comprise a housing base, wherein the carrier substrate is arranged at least in part on the housing base. Especially the sections comprising the first landing pads and/or the second landing pads may protrude from the housing base.

A housing base may accommodate a single carrier substrate or multiple carrier substrates and fix the carrier substrate(s) in a predefined position. The housing base also provides mechanical protection for the carrier substrate(s).

In embodiments, a housing cover may be provided on the housing base. The housing cover and the housing base together create an inner housing cavity that accommodates at least part of the carrier substrate(s). Especially, those parts or sections of the carrier substrate(s) may protrude from the housing that carry the first landing pad(s).

Of course, the housing may also provide an electrical shielding of the components of the power calibration adapter.

In an embodiment, which can be combined with all other embodiments of the power calibration adapter mentioned above or below, the carrier substrate may be fixed to the housing base, especially by at least one of gluing, soldering, screwing and clamping.

The carrier substrate(s) may, in embodiments, be fixed to the housing base. Such embodiments may provide a very rigid and sturdy power calibration adapter. Such an adapter may especially be used in heavy-duty environments.

In another embodiment, which can be combined with all other embodiments of the power calibration adapter mentioned above or below, the carrier substrate may be releasably arranged on the housing base. For this type of arranging the carrier substrate on the housing base, the screwing and/or clamping variants may especially be used.

Providing the first landing pads and/or the second landing pads on a substrate that is releasably arranged on the housing base, allows easily exchanging the respective landing pads when required. This may, for example, be the case if the respective landing pads wear out and need to be replaced.

Instead of replacing the power calibration adapter, with releasable carrier substrate(s), it is possible to only replace the carrier substrate(s) with the respective landing pads. If multiple different carrier substrates are used, it is even possible, to only replace those landing pads that suffered the most wear.

In yet another embodiment, which can be combined with all other embodiments of the power calibration adapter mentioned above or below, the power calibration adapter may comprise a power measurement unit that is coupled to the at least one first landing pad.

In order to perform a power measurement for the wafer prober tip, a respective power measurement unit may be implemented in the power calibration adapter, especially on the carrier substrate. Such a power measurement unit may be implemented, for example, as a power measurement cell disclosed in patent application WO2010054811A1 or patent DE102008057607B4.

With the power measurement unit being integrated in the power calibration adapter, the power measurement may be easily performed near the respective first landing pad, without requiring a complex power measurement setup.

In an embodiment, which can be combined with all other embodiments of the power calibration adapter mentioned above or below, the power measurement unit may be formed on the carrier substrate.

It is understood, that the power measurement unit may be formed on the same carrier substrate as the respective first landing pad, or on a dedicated carrier substrate. Providing a dedicated carrier substrate for the power measurement unit allows exchanging only the first landing pad when required, without the need to exchange the power measurement unit at the same time.

If different carrier substrates are used for different elements of the power calibration adapter that need to be electrically coupled to each other, the carrier substrates or conductors on the carrier substrates may be coupled to each other, for example, via respective bond wires.

In embodiments, the power measurement unit may output an analog value that may be measured by a respective measurement device via the power meter interface. In other embodiments, a control unit may be provided in addition to or integrated into the power measurement unit. Such a control unit may comprise an analog-to-digital converter and may, for example, comprise a digital communication interface to output the measured power value. Such a digital communication interface may comprise any adequate type of interface, for example, a USB interface, a serial data interface, and a network interface.

If required, the power meter interface may also be used to supply electrical supply power to the power measurement unit.

In a further embodiment, which can be combined with all other embodiments of the power calibration adapter mentioned above or below, the at least one power meter interface may comprise a connector configured to couple to an external power measurement device.

The power meter interface may instead of connecting a measurement device to an internal power measurement unit, also couple an external power measurement unit to the respective first landing pad.

The connector may in embodiments comprise a coaxial-type connector that is electrically coupled to the respective first landing pad.

In embodiments, the connector may comprise a waveguide connector. Internally, a waveguide may be coupled inductively or capacitively to the first landing pad and/or a conductor on the carrier substrate.

In a further embodiment, which can be combined with all other embodiments of the power calibration adapter mentioned above or below, the power calibration adapter may further comprise a switching unit and a signal output interface for at least one of the first landing pads, the switching unit being configured to controllably couple the respective one of the first landing pads to the respective power meter interface or to the respective signal output interface.

The switching unit may be provided internally in the power calibration adapter. The switching unit serves to conduct a signal from the respective first landing pad either to a power measuring device coupled to the respective power meter interface, or to the signal output interface. In a measurement application system, a measurement device, like a vector network analyzer, may be coupled to the signal output interface.

The switching unit may in embodiments be manually controlled. In other embodiments, the switching unit may be controller by a respective control unit, for example, a control unit that controls a calibration process in the measurement application system.

With the signal output interface, it is possible to controllably couple the first landing pad to a measurement device for determining calibration parameters of the power calibration adapter itself, whenever required.

After determining the calibration parameters for the measurement device, the power calibration for a wafer prober tip may be performed.

In another embodiment, which can be combined with all other embodiments of the power calibration adapter mentioned above or below, the power calibration adapter may further comprise a switching unit, a power meter output port and a signal output port for at least one of the power meter interfaces, the switching unit being configured to controllably couple the respective one of the power meter interfaces to the respective signal output port or the respective power meter output port.

In this embodiment, the switching unit not necessarily needs to be provided in the power calibration adapter, or the housing of the power calibration adapter. Instead, the switching unit may be provided as external switching unit, that may be coupled to the respective power meter interface on one side, and to the power meter output port and the signal output port on the other side.

For the external switching unit, the explanations provided above for the internal switching unit apply mutatis mutandis.

In embodiments, the switching unit may be provided as a reciprocal switching unit. This means, that both signal paths through the switching unit comprise the same power loss.

### BRIEF DESCRIPTION OF THE DRAWINGS

For a more complete understanding of the present disclosure and advantages thereof, reference is now made to the following description taken in conjunction with the accompanying drawings. The disclosure is explained in more detail below using exemplary embodiments which are specified in the schematic figures of the drawings, in which:
Figure 1 shows a block diagram of an embodiment of a power calibration adapter according to the present disclosure;
Figure 2 shows a block diagram of another embodiment of a power calibration adapter according to the present disclosure;
Figure 3 shows a block diagram of a further embodiment of a power calibration adapter according to the present disclosure;
Figure 4 shows a block diagram of another embodiment of a power calibration adapter according to the present disclosure;
Figure 5 shows a block diagram of an embodiment of a measurement application system according to the present disclosure;
Figure 6 shows a schematic diagram of a further embodiment of a power calibration adapter according to the present disclosure;
Figure 7 shows a block diagram of another embodiment of a measurement application system according to the present disclosure;
Figure 8 shows a block diagram of a further embodiment of a measurement application system according to the present disclosure;
Figure 9 shows a schematic diagram of another embodiment of a power calibration adapter according to the present disclosure;
Figure 10 shows a schematic diagram of a further embodiment of a power calibration adapter according to the present disclosure;
Figure 11 shows a schematic diagram of another embodiment of a power calibration adapter according to the present disclosure;
Figure 12 shows a schematic diagram of a further embodiment of a power calibration adapter according to the present disclosure;
Figure 13 shows a schematic diagram of another embodiment of a power calibration adapter according to the present disclosure;
Figure 14 shows a flow diagram of an embodiment of a method according to the present disclosure; and
Figure 15 shows a block diagram of an embodiment of a wafer prober for use with an embodiment of a power calibration adapter according to the present disclosure.

In the figures like reference signs denote like elements unless stated otherwise.

### DETAILED DESCRIPTION OF THE DRAWINGS

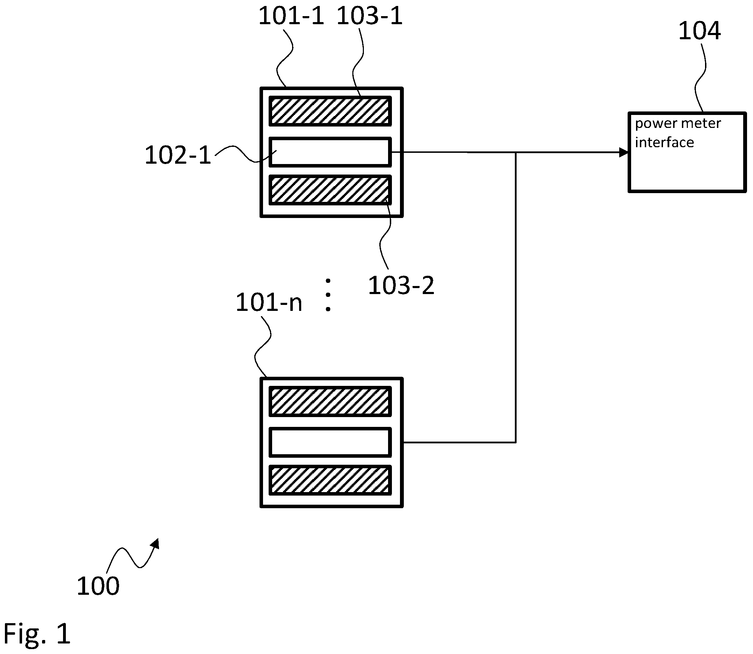

Figure 1 shows a block diagram of a power calibration adapter 100 for wafer probers. The power calibration adapter 100 comprises a number of first landing pads 101-1 - 101-n. While two first landing pads 101-1 - 101-n are shown, it is indicated by three dots that any number of first landing pads 101-1 - 101-n from one first landing pad 101-1 to a plurality of first landing pads 101-1 - 101-n is possible. The first landing pads 101-1 - 101-n are coupled to a power meter interface 104.

The power meter interface 104 is only schematically shown as a single unit. It is understood, that a single connector or coupling may be provided as power meter interface 104 for each one of the first landing pads 101-1 - 101-n.

Each one of the first landing pads 101-1 - 101-n serves for releasably contacting a wafer prober tip. To this end, the first landing pads 101-1 - 101-n may each comprise a single contacting area.

However, in embodiments, like shown in the power calibration adapter 100, the first landing pads 101-1 - 101-n may comprise multiple contacting areas. In the power calibration adapter 100, each one of the first landing pads 101-1 - 101-n comprises a signal contacting area 102, and two ground contacting areas 103-1, 103-2 at two opposing sides of the first landing pads 101-1 - 101-n. Such first landing pads 101-1 - 101-n allow calibrating a wafer prober with multiple probe tips per probing point i.e., a signal probe tip and one or two ground probe tips.

For performing a power calibration of a probe tip or probe tips, the respective probe tip or probe tips, may be lowered onto the signal contacting area 102, and the ground contacting areas 103-1, 103-2. The power meter interface 104 may couple the first landing pads 101-1 - 101-n to a power measurement device or unit that may then perform the power calibration for the respective probe tips.

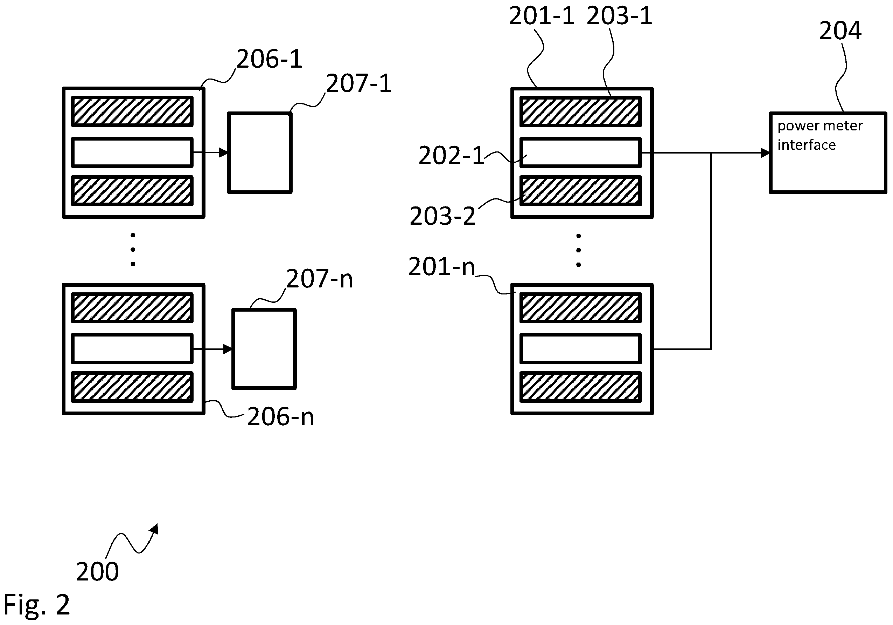

Figure 2 shows a block diagram of another power calibration adapter 200. The power calibration adapter 200 is based on the power calibration adapter 100. The power calibration adapter 200, therefore, comprises a number of first landing pads 201-1 - 201-n, that are coupled to a power meter interface 204. The explanations provided above for the power calibration adapter 100 apply mutatis mutandis.

In addition, the power calibration adapter 200 comprises a number i.e., one or more, of second landing pads 206-1 - 206-n. Each one of the second landing pads 206-1 - 206-n is coupled to a respective calibration standard 207-1 - 207-n.

The second landing pads 206-1 - 206-n with the calibration standards 207-1 - 207-n serve to determine further properties, either of the power calibration adapter 200 or the probe tips that are to be calibrated, in order to determine error terms of an error model that may later be used in a measurement application with the respective probe tips to correct the measurements accordingly.

The calibration standards 207-1 - 207-n may exemplarily comprise at least one of an open calibration standard, a short calibration standard, and a match calibration standard. These types of calibration standards may each be coupled to a single one of the second landing pads 206-1 - 206-n. Other possible types of calibration standards 207-1 - 207-n may each be coupled to two of the second landing pads 206-1 - 206-n. Such calibration standards 207-1 - 207-n may comprise, but are not limited to, at least one of a through calibration standard, and a line calibration standard.

The calibration standards 207-1 - 207-n are shown as dedicated elements in the power calibration adapter 200, that are each coupled to a respective one of the second landing pads 206-1 - 206-n. In embodiments, the calibration standards 207-1 - 207-n may be provided as part of or integrated into the respective second landing pads 206-1 - 206-n, as will be explained in more detail below.

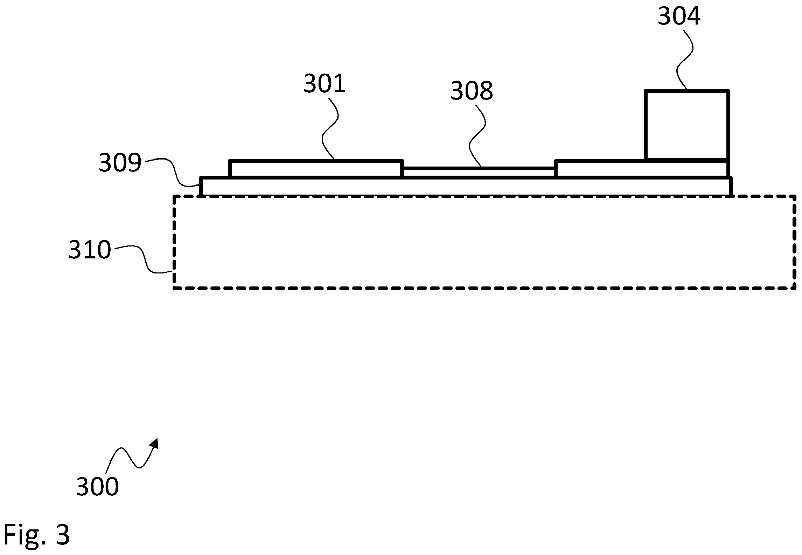

Figure 3 shows a block diagram of a power calibration adapter 300 in a side view. The power calibration adapter 300 is based on the power calibration adapter 100. Therefore, the power calibration adapter 300 comprises a first landing pad 301 that is coupled to a power meter interface 304. While only one first landing pad 301 with one corresponding power meter interface 304 is shown, more are possible. The explanations provided regarding the power calibration adapter 100 apply mutatis mutandis.

In the power calibration adapter 300, the first landing pad 301 and the power meter interface 304 are provided by a carrier substrate 309 and are coupled to each other via a trace 308. The carrier substrate 309 with the first landing pad 301, the power meter interface 304, and the carrier substrate 309 are provided on a housing base 310. Although not explicitly shown, it is understood, that a housing cover may also be provided to cover at least part of the housing base 310 with the carrier substrate 309.

In embodiments, the first landing pad 301 and the power meter interface 304 may be provided on different carrier substrates 309. Further, one or at least one of multiple carrier substrates 309 may be fixed to the housing base 310 reversibly or releasably e.g., by screwing or clamping. Other carrier substrates 309 may be irreversibly fixed to the carrier substrate 309 e.g., by gluing or soldering.

Such an arrangement allows for example, providing the power meter interface 304 on a carrier substrate 309 that is irreversibly fixed to the housing base 310, while the first landing pads 301 may be provided on a carrier substrate 309 that is releasably fixed to the housing base 310. Worn-out first landing pads 301 may in such embodiments be easily replaced by replacing only the respective carrier substrate 309.

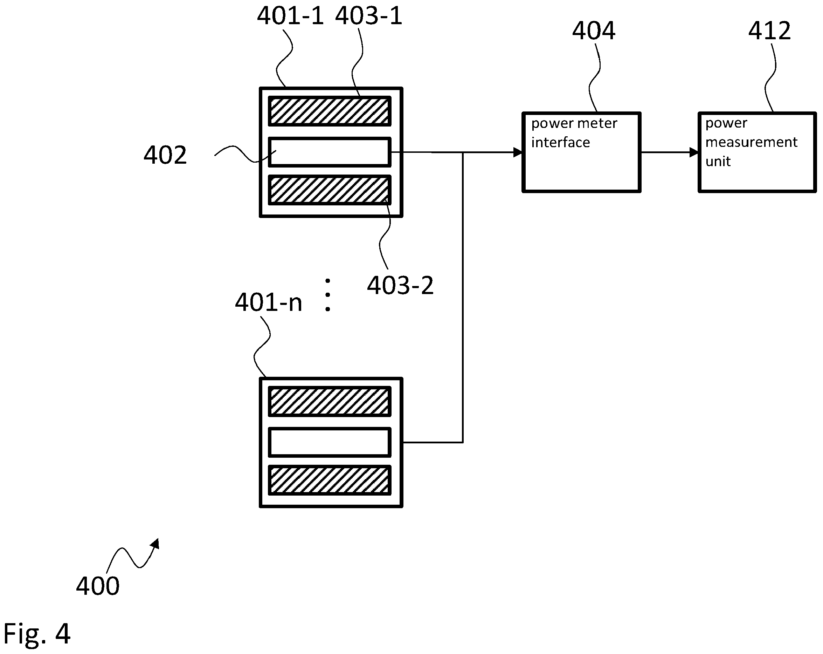

Figure 4 shows a block diagram of a power calibration adapter 400. The power calibration adapter 400 is based on the power calibration adapter 100. Therefore, the power calibration adapter 400 comprises a number of first landing pads 401-1 - 401 - n, that are coupled to a power meter interface 404. The explanations provided above for the power calibration adapter 100 apply mutatis mutandis.

The power calibration adapter 400 further comprises a power measurement unit 412 that is coupled to the power meter interface 404. The power measurement unit 412 may be an internal power measurement unit 412 of the power calibration adapter 400, like a power measurement cell as indicated above. Of course, an analog or a digital interface may be provided for reading out such an integrated power measurement unit 412.

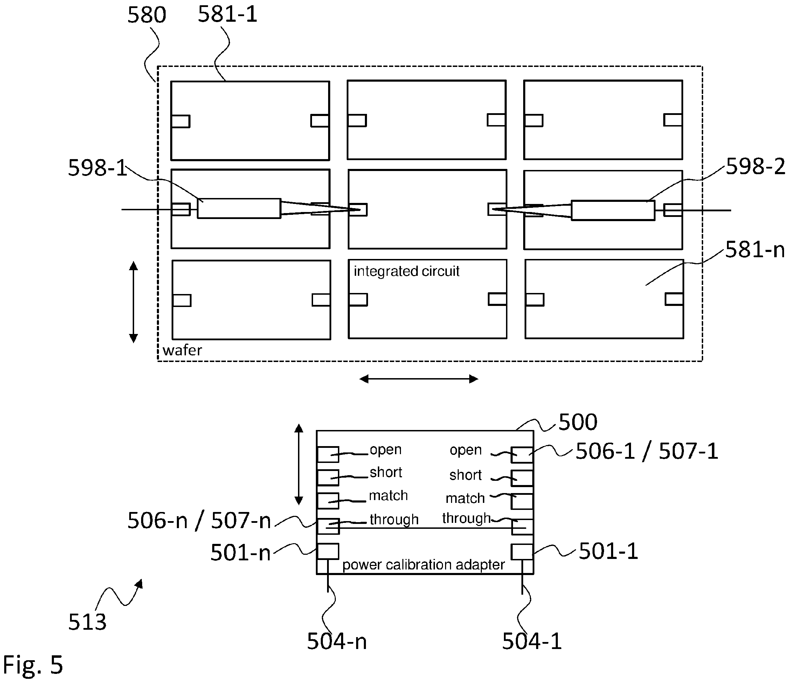

Figure 5 shows a block diagram of a measurement application system 513. The measurement application system 513 comprises a power calibration adapter 500 for calibrating probes 598-1, 598-2 i.e., the wafer prober tips of the probes 598-1, 598-2, that are used to measure electrical characteristics of integrated circuits 581-1 - 581-n that are provided on a wafer 580.

The power calibration adapter 500 comprises two first landing pads 501-1 - 501-2 that each serve for power calibration of one of the probes 598-1, 598-2. In addition, the power calibration adapter 500 comprises eight second landing pads 506-1 - 506-8 that each are coupled to or comprise a respective calibration standard 507-1 - 507-8, like an open calibration standard, a short calibration standard, a match calibration standard, and a through calibration standard. It is understood, that more or less second landing pads with respective calibration standards are possible.

The wafer 580 may be movably arranged under the probes 598-1, 598-2 in order to position single ones of the integrated circuits 581-1 - 581-n under the probes 598-1, 598-2.

For calibrating the probes 598-1, 598-2, the wafer 580 may be moved away and the power calibration adapter 500 may be moved under the probes 598-1, 598-2. In other embodiments, the probes 598-1, 598-2 may be movably arranged and may be moved to the power calibration adapter 500.

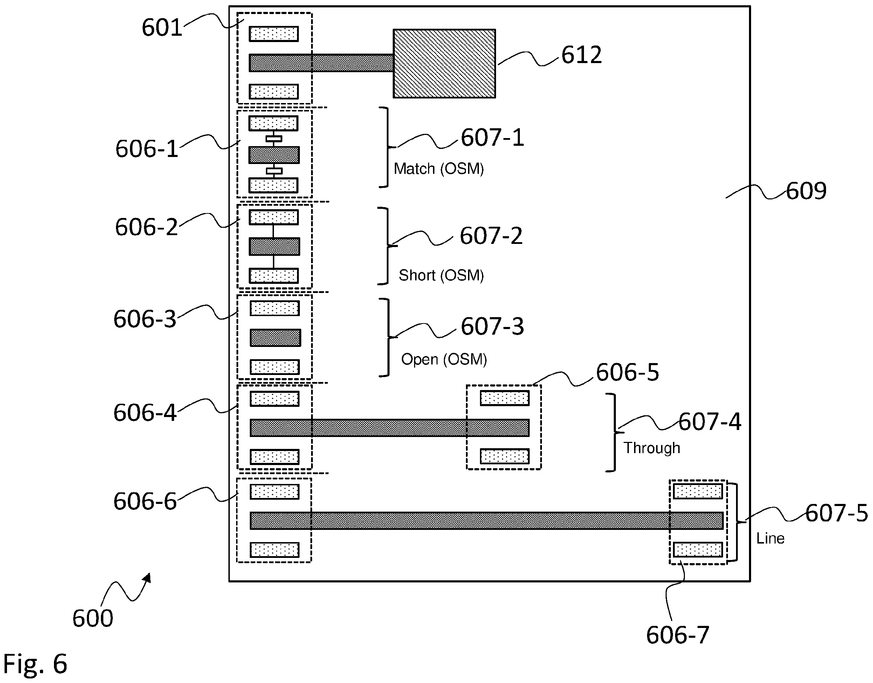

Figure 6 shows a block diagram of a power calibration adapter 600. The power calibration adapter 600 comprises a carrier substrate 609. On the carrier substrate 609, a first landing pad 601 is provided that is coupled to a power measurement unit 612 e.g., a power measurement cell as indicated above. It is understood, that an interface for reading out a measured power level from the power measurement unit 612 may be provided.

In addition, the power calibration adapter 600 comprises seven second landing pads 606-1 - 606-7, wherein the second landing pad 606-1 is coupled to a match calibration standard 607-1, the second landing pad 606-2 is coupled to a short calibration standard 607-2, and the second landing pad 606-3 is coupled to an open calibration standard 607-3. The second landing pads 606-4 and 606-5 are coupled to each other via a trace and form a through calibration standard 607-4. The second landing pads 606-6 and 606-7 are coupled to each other via a trace and form a line calibration standard 607-5.

Each one of the second landing pads 606-1 - 606-7 comprises a signal contacting area and two ground contacting areas, not explicitly referenced. With such an arrangement, the match calibration standard 607-1 may be provided by providing electric components with a predetermined impedance between the signal contacting area and each one of the ground contacting areas. The short calibration standard 607-1 may be provided by providing electric connections between the signal contacting area and each one of the ground contacting areas, and the open calibration standard 607-1 may be provided by providing no electric connection between the signal contacting area and each one of the ground contacting areas.

As may be seen, all the elements of the power calibration adapter 600 may be implemented on the carrier substrate 609. Such a power calibration adapter 600 may, therefore, be easily manufactured using methods of manufacturing circuits on carrier substrates.

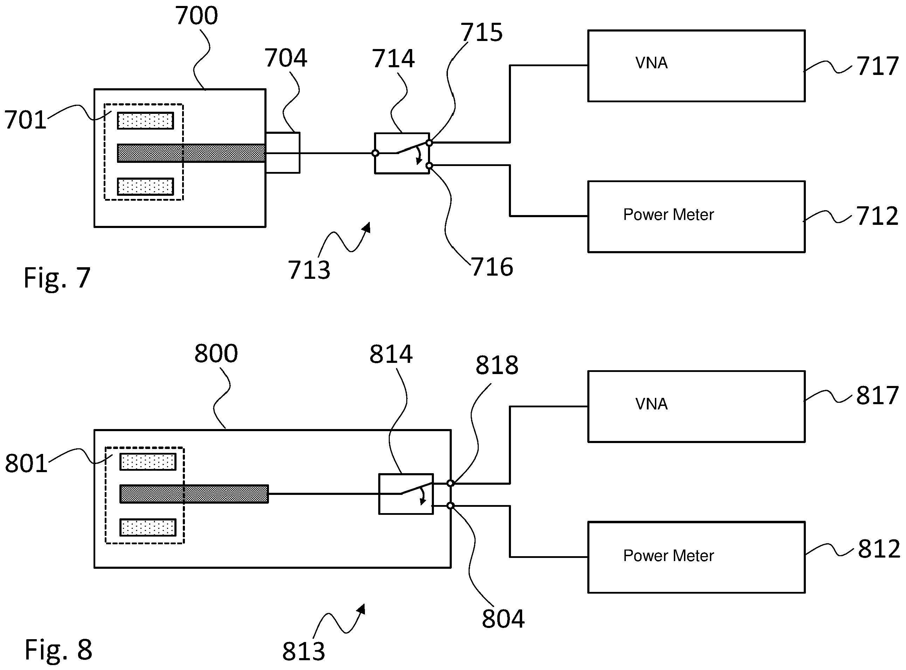

Figure 7 shows a block diagram of another embodiment of a measurement application system 713. The measurement application system 713 comprises a power calibration adapter 700 with a first landing pad 701 that is coupled to a power meter interface 704. It is understood, that any other embodiment of a power calibration adapter disclosed herein may be used in the measurement application system 713. The measurement application system 713 further comprises a switching unit 714 that is on a common input coupled to the power meter interface 704 and that comprises a signal output port 715 and a power meter output port 716. The switching unit 714 may controllably couple either the signal output port 715 or the power meter output port 716 to the common port i.e. to the power meter interface 704.

The measurement application system 713 further comprises a signal measurement device 717 coupled to the signal output port 715, and a power measurement unit 712 coupled to the power meter output port 716.

With the measurement application system 713 it is possible to couple the first landing pad 701 either to the power meter output port 716 or the signal measurement device 717.

Figure 8 shows a block diagram of another measurement application system 813. The measurement application system 813 is based on the measurement application system 713. Therefore, the measurement application system 813 comprises a power calibration adapter 800 with a first landing pad 801. The explanations provided above for the measurement application system 713 apply mutatis mutandis.

In the measurement application system 813, a switching unit 814 is integrated into the power calibration adapter 800. The common port of the switching unit 814 is coupled to the first landing pad 801. One of the output ports of the switching unit 814 is coupled to the power meter interface 804 of the power calibration adapter 800, while the other output port of the switching unit 814 is coupled to a signal output interface 818 of the power calibration adapter 800.

A power measurement unit 812 is coupled to the power meter interface 804, and a signal measurement device 817 is coupled to the signal output interface 818.

As with the measurement application system 713, the measurement application system 813 allows flexibly coupling the first landing pad 801 either with the power measurement unit 812 or the signal measurement device 817.

With a measurement application system according to the present disclosure, different types of calibrations may be performed with a wafer prober tip. In a simply embodiment, a 1-port calibration, like a OSM, TOSM, or UOSM calibration, of a measurement application device like a vector network analyzer with a wafer prober tip coupled to that port may be performed, the wafer prober tip forming the reference plane. The wafer prober tip may then be positioned on the respective first landing pad of a power calibration adapter and an error correction model for the power calibration adapter may be applied to the measurements. The power calibration at the wafer prober tip may then be performed with the error corrected measurements. The error correction model may be provided, for example, by a manufacturer of the power calibration adapter.

In another embodiment, a 2-port measurement may be performed after performing an initial 1-port calibration on 2-ports of the measurement application device, one port with the wafer prober tip connected, and one port with the reference plane at the power meter interface. After performing the 1-port calibrations, a full multi-port system error correction may be performed for the power calibration adapter. This calibration may, especially, be performed with a measurement application system like the one shown in figure 7 or 8 by coupling the power calibration adapter 700 or 800 to the signal measurement device via the respective switching device. After performing this correction for the adapter, the power calibration may be performed for the wafer prober tip. To this end, the power measurement unit may be coupled to the power calibration adapter 700 or 800 via the respective switching unit. The power calibration may then be determined based on the measurements of the power measurement unit and the error correction performed for the power calibration adapter.

In a further alternative embodiment, instead of measuring the properties of the power calibration adapter, a calibration standard, especially a short calibration standard, may be provided on the power meter interface. This calibration standard will lead to a reflection of any signal that is provided to the power calibration adapter via a wafer prober tip. Like in the embodiment described above, a full multi-port system error correction may be performed for the power calibration adapter, but based on the reflected signal instead of a dedicated measurement.

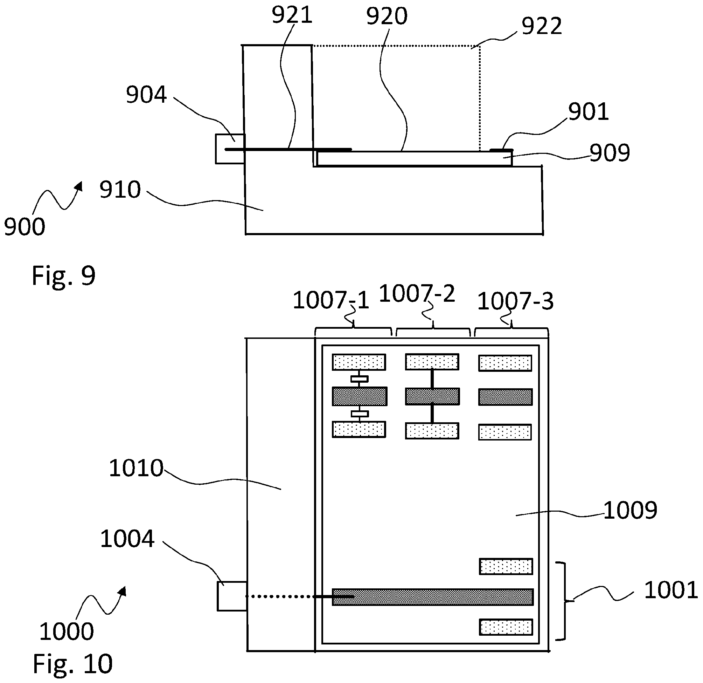

Figure 9 shows a schematic diagram of a power calibration adapter 900 in a side view. The power calibration adapter 900 comprises a housing base 910. The housing base 910 carries a carrier substrate 909 with a first landing pad 901 that is coupled via a transmission line 920 to an inner conductor 921 that is coupled to a power meter interface 904.

An optional housing cover 922 is shown. The housing cover 922 is configured such, that it covers only part of the carrier substrate 909, such that the first landing pad 901 is accessible for a probe tip while the housing cover 922 is installed. If second landing pads are present in an embodiment, the housing cover 922 may also leave the second landing pads uncovered.

Figure 10 shows a schematic diagram of a power calibration adapter 1000 in a top view. The power calibration adapter 1000 comprises a carrier substrate 1009 that is provided on a housing base 1010.

On the carrier substrate 1009 a first landing pad 1001 is provided that is coupled to a power meter interface 1004 e.g., a BNC connector. Further, three second landing pads forming calibration standards 1007-1 - 1007-3 are provided. The power calibration adapter 1000 shows an alternative arrangement to the power calibration adapter 600 without the internal power measurement cell and a connector as power meter interface 1004.

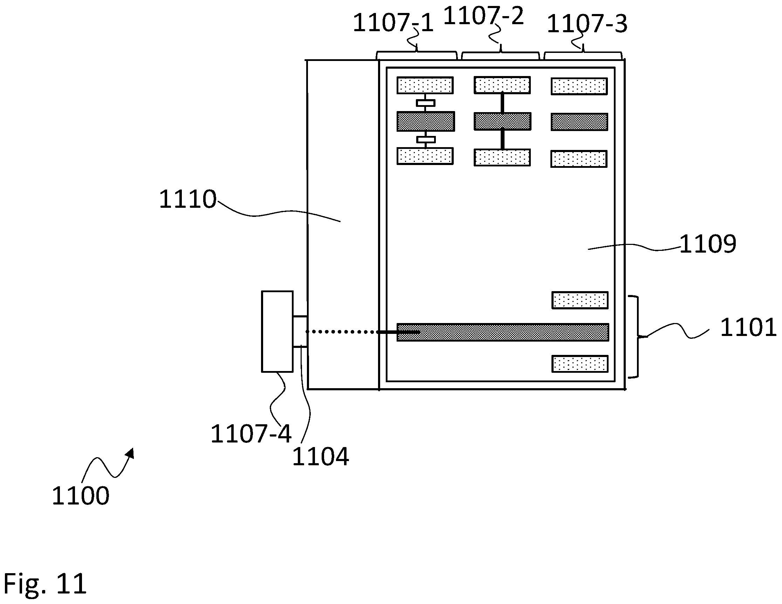

Figure 11 shows a schematic diagram of a power calibration adapter 1100. The power calibration adapter 1100 is based on the power calibration adapter 1000 and comprises a carrier substrate 1109 that is provided on a housing base 1110. On the carrier substrate 1109 a first landing pad 1101 is provided that is coupled to a power meter interface 1104 e.g., a BNC connector. Further, three second landing pads forming calibration standards 1107-1 - 1107-3 are provided.

In the power calibration adapter 1100, a short calibration standard 1107-4 is releasably coupled to the power meter interface 1104. Such a short calibration standard 1107-4 may, for example, be provided in the form of a calibration standard integrated into a BNC coupling or cap that may be screwed onto the power meter interface 1104.

With a short calibration standard 1107-4 on the power meter interface 1104, measurements of characteristics of a signal path from the first landing pad 1101 to the power meter interface 1104 may be performed.

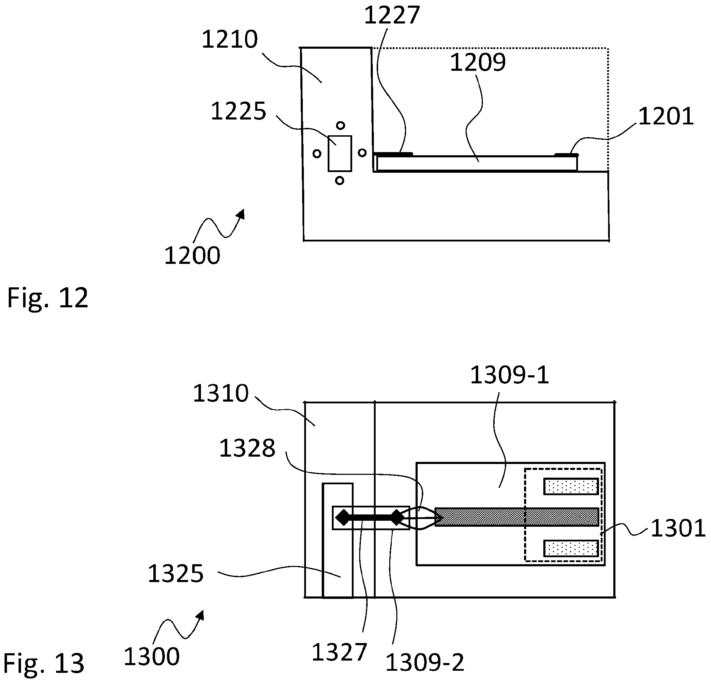

Figure 12 shows a schematic diagram of a power calibration adapter 1200 in a side view. The power calibration adapter 1200 is based on the power calibration adapter 900 and comprises a housing base 1210 with a carrier substrate 1209 with a first landing pad 1201. A trace 1227 couples the first landing pad 1201 to a waveguide 1225. The trace 1227 may, for example, be coupled to the waveguide 1225 via an inductive or capacitive coupling. Four screw holes are schematically shown for coupling an external waveguide to the waveguide in the housing base 1210.

Figure 13 shows a block diagram of a power calibration adapter 1300 in a top view. The power calibration adapter 1300 comprises a housing base 1310 that carries a first carrier substrate 1309-1 and a second carrier substrate 1309-2. The first carrier substrate 1309-1 comprises a first landing pad 1301. The second carrier substrate 1309-2 comprises a trace 1327 that couples the first landing pad 1301 with a waveguide 1325.

The first carrier substrate 1309-1 and the second carrier substrate 1309-2 are coupled to each other by bond wires 1328.

The arrangement of the power calibration adapter 1300 allows easily exchanging the first carrier substrate 1309-1, when necessary, while the second carrier substrate 1309-2 may be kept in the power calibration adapter 1300.

It is understood, that the bond wires 1328 are just an example of coupling the first carrier substrate 1309-1 to the second carrier substrate 1309-2, and that any other type of coupling is possible.

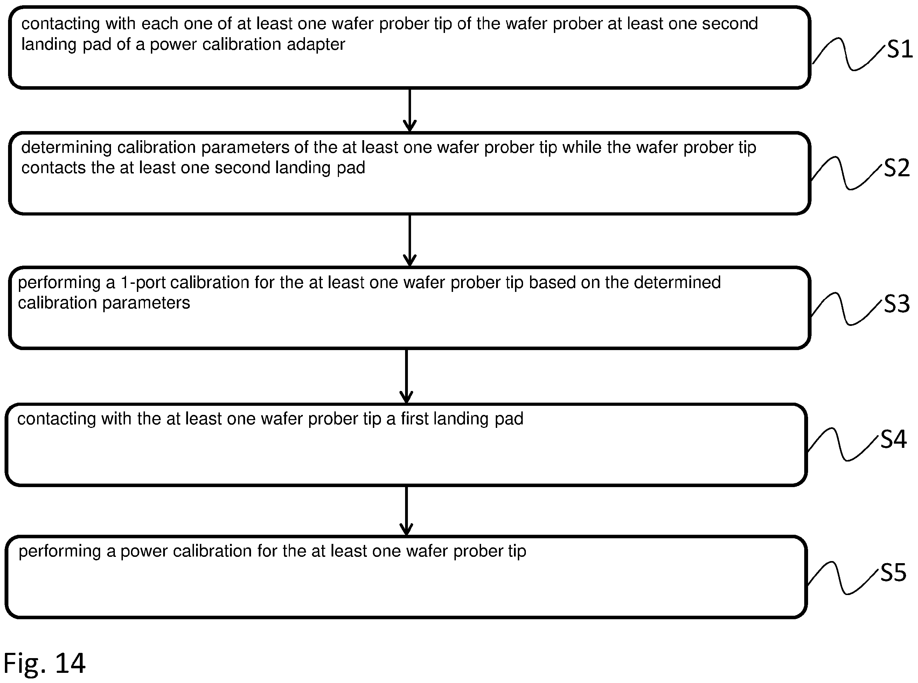

For sake of clarity in the following description of the method-based Fig. 14 the reference signs used in the description of apparatus based Figs. 1 - 13 and 15 will be maintained.

Figure 14 shows a flow diagram of a method for calibrating a wafer prober 1599. The method comprises contacting S1 with each one of at least one wafer prober tip of the wafer prober 1599 at least one second landing pad 206-1 - 206-n, 506-1 - 506-8, 606-1 - 606-7 of a power calibration adapter 100, 200, 300, 400, 500, 600, 700, 800, 900, 1000, 1100,1200, 1300, determining S2 calibration parameters of the at least one wafer prober tip while the wafer prober tip contacts the at least one second landing pad 206-1 - 206-n, 506-1 - 506-8, 606-1 - 606-7, performing S3 a 1-port calibration for the at least one wafer prober tip based on the determined calibration parameters, contacting S4 with the at least one wafer prober tip a first landing pad 101-1 - 101-n, 201-1 -201-n, 301, 401-1 - 401-n, 501-1 - 501-2, 601, 701, 801, 901, 1001, 1101, 1201, 1301, and performing S5 a power calibration for the at least one wafer prober tip.

Of course, the 1-port calibration and the power calibration may be corrected with correction parameters of the power calibration adapter 100, 200, 300, 400, 500, 600, 700, 800, 900, 1000, 1100,1200, 1300, especially a reflection characteristic and/or a transmission characteristic of the power calibration adapter 100, 200, 300, 400, 500, 600, 700, 800, 900, 1000, 1100,1200, 1300.

Two first landing pads 101-1 - 101-n, 201-1 - 201 -n, 301, 401-1 - 401 -n, 501-1 - 501-2, 601, 701, 801, 901, 1001, 1101, 1201, 1301 that are coupled to each other via a through calibration standard or a line calibration standard in the power calibration adapter 100, 200, 300, 400, 500, 600, 700, 800, 900, 1000, 1100,1200, 1300 may be contacted with two wafer prober tips, wherein a 2-port calibration may be performed for the two waver prober tips.

Also, the 2-port calibration may be corrected with correction parameters of the power calibration adapter 100, 200, 300, 400, 500, 600, 700, 800, 900, 1000, 1100,1200, 1300, especially a reflection characteristic and/or a transmission characteristic of the power calibration adapter 100, 200, 300, 400, 500, 600, 700, 800, 900, 1000, 1100,1200, 1300.

The method may also comprise determining correction parameters for the power calibration adapter 100, 200, 300, 400, 500, 600, 700, 800, 900, 1000, 1100,1200, 1300 by coupling the wafer prober tip to a second port of the measurement device, coupling the first landing pad 101-1 - 101 -n, 201-1 - 201 -n, 301, 401-1 - 401 -n, 501 - 1 - 501-2, 601, 701, 801, 901, 1001, 1101, 1201, 1301 to a first port of a measurement device while the wafer prober tip is connected to the first landing pad 101-1 - 101-n, 201-1 -201-n, 301, 401-1 - 401-n, 501-1 - 501-2, 601, 701, 801, 901, 1001, 1101, 1201, 1301, and determining correction parameters of the power calibration adapter 100, 200, 300, 400, 500, 600, 700, 800, 900, 1000, 1100,1200, 1300 in the measurement device.

Further, the wafer prober tip may be coupled to a port of a measurement signal generation device, and the first landing pad 101-1 - 101-n, 201-1 - 201-n, 301, 401-1 - 401-n, 501-1 - 501-2, 601, 701, 801, 901, 1001, 1101, 1201, 1301 may be coupled to a power measurement unit 412, 612, 712, 812 while the wafer prober tip is connected to the first landing pad 101-1 - 101-n, 201-1 - 201-n, 301, 401-1 - 401-n, 501-1 - 501-2, 601, 701, 801, 901, 1001, 1101, 1201, 1301. The method may then comprise outputting a calibration signal via the port of the measurement signal generation device, and determining a power correction parameter for the measurement signal generation device in the power measurement unit 412, 612, 712, 812 based on the calibration signal.

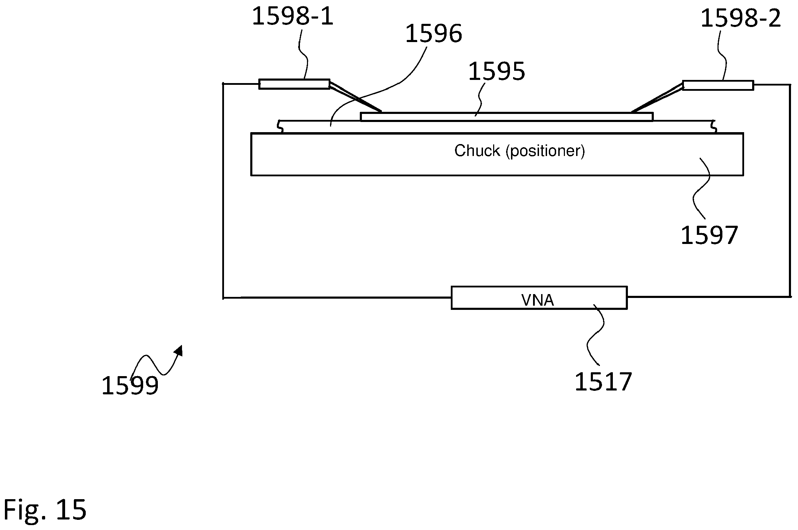

Figure 15 shows a block diagram of an embodiment of a wafer prober 1599 for use with an embodiment of a power calibration adapter according to the present disclosure.

The wafer prober 1599 comprises a chuck 1597 for positioning a wafer 1596. On the wafer 1596 an integrated circuit 1595 is provided. The wafer prober 1599 comprises two probes 1598-1, 1598-2 for measuring electrical characteristics of the integrated circuit 1595, which are both coupled to a signal measurement device 1517.

The processes, methods, or algorithms disclosed herein can be deliverable to/implemented by a processing device, controller, or computer, which can include any existing programmable electronic control unit or dedicated electronic control unit. Similarly, the processes, methods, or algorithms can be stored as data and instructions executable by a controller or computer in many forms including, but not limited to, information permanently stored on non-writable storage media such as ROM devices and information alterably stored on writeable storage media such as floppy disks, magnetic tapes, CDs, RAM devices, and other magnetic and optical media. The processes, methods, or algorithms can also be implemented in a software executable object. Alternatively, the processes, methods, or algorithms can be embodied in whole or in part using suitable hardware components, such as Application Specific Integrated Circuits (ASICs), Field-Programmable Gate Arrays (FPGAs), state machines, controllers or other hardware components or devices, or a combination of hardware, software and firmware components.

While exemplary embodiments are described above, it is not intended that these embodiments describe all possible forms encompassed by the claims. The words used in the specification are words of description rather than limitation, and it is understood that various changes can be made without departing from the spirit and scope of the disclosure. As previously described, the features of various embodiments can be combined to form further embodiments of the invention that may not be explicitly described or illustrated. While various embodiments could have been described as providing advantages or being preferred over other embodiments or prior art implementations with respect to one or more desired characteristics, those of ordinary skill in the art recognize that one or more features or characteristics can be compromised to achieve desired overall system attributes, which depend on the specific application and implementation. These attributes can include, but are not limited to cost, strength, durability, life cycle cost, marketability, appearance, packaging, size, serviceability, weight, manufacturability, ease of assembly, etc. As such, to the extent any embodiments are described as less desirable than other embodiments or prior art implementations with respect to one or more characteristics, these embodiments are not outside the scope of the disclosure and can be desirable for particular applications.

With regard to the processes, systems, methods, heuristics, etc. described herein, it should be understood that, although the steps of such processes, etc. have been described as occurring according to a certain ordered sequence, such processes could be practiced with the described steps performed in an order other than the order described herein. It further should be understood that certain steps could be performed simultaneously, that other steps could be added, or that certain steps described herein could be omitted. In other words, the descriptions of processes herein are provided for the purpose of illustrating certain embodiments, and should in no way be construed so as to limit the claims.

Accordingly, it is to be understood that the above description is intended to be illustrative and not restrictive. Many embodiments and applications other than the examples provided would be apparent upon reading the above description. The scope should be determined, not with reference to the above description, but should instead be determined with reference to the appended claims, along with the full scope of equivalents to which such claims are entitled. It is anticipated and intended that future developments will occur in the technologies discussed herein, and that the disclosed systems and methods will be incorporated into such future embodiments. In sum, it should be understood that the application is capable of modification and variation.

All terms used in the claims are intended to be given their broadest reasonable constructions and their ordinary meanings as understood by those knowledgeable in the technologies described herein unless an explicit indication to the contrary in made herein. In particular, use of the singular articles such as "a," "the," "said," etc. should be read to recite one or more of the indicated elements unless a claim recites an explicit limitation to the contrary.

The abstract of the disclosure is provided to allow the reader to quickly ascertain the nature of the technical disclosure. It is submitted with the understanding that it will not be used to interpret or limit the scope or meaning of the claims. In addition, in the foregoing Detailed Description, it can be seen that various features are grouped together in various embodiments for the purpose of streamlining the disclosure. This method of disclosure is not to be interpreted as reflecting an intention that the claimed embodiments require more features than are expressly recited in each claim. Rather, as the following claims reflect, inventive subject matter lies in less than all features of a single disclosed embodiment. Thus, the following claims are hereby incorporated into the Detailed Description, with each claim standing on its own as a separately claimed subject matter.

While exemplary embodiments are described above, it is not intended that these embodiments describe all possible forms of the invention. Rather, the words used in the specification are words of description rather than limitation, and it is understood that various changes may be made without departing from the spirit and scope of the invention. Additionally, the features of various implementing embodiments may be combined to form further embodiments of the invention.

The present disclosure provides the following further embodiments:
In an embodiment, which can be combined with all other embodiments of the measurement application system mentioned above or below, the measurement application system may further comprise a signal measurement device, especially a vector network analyzer, configured to receive measurement signals from the power calibration adapter and determine calibration parameters for the power calibration adapter.

In an embodiment, which can be combined with all other embodiments of the method mentioned above or below, two first landing pads that are coupled to each other via a through calibration standard or a line calibration standard in the power calibration adapter may be contacted with two wafer prober tips, wherein a 2-port calibration may be performed for the two waver prober tips.

In an embodiment, which can be combined with all other embodiments of the method mentioned above or below, the 2-port calibration may be corrected with correction parameters of the power calibration adapter, especially a reflection characteristic and/or a transmission characteristic of the power calibration adapter.

In an embodiment, which can be combined with all other embodiments of the method mentioned above or below, the method may further comprise determining correction parameters for the power calibration adapter by coupling the wafer prober tip to a second port of the measurement device; coupling the first landing pad to a first port of a measurement device while the wafer prober tip is connected to the first landing pad; and determining correction parameters of the power calibration adapter in the measurement device.

In an embodiment, which can be combined with all other embodiments of the method mentioned above or below, the method may further comprise coupling the wafer prober tip to a port of a measurement signal generation device; coupling the first landing pad to a power measurement unit while the wafer prober tip is connected to the first landing pad; outputting a calibration signal via the port of the measurement signal generation device; and determining a power correction parameter for the measurement signal generation device in the power measurement unit based on the calibration signal.

### LIST OF REFERENCE SIGNS

- 100, 200, 300, 400, 500, 600, 700, 800: power calibration adapter
- 900, 1000, 1100,1200, 1300: power calibration adapter
- 101-1 - 101-n, 201-1 - 201-n, 301: first landing pad
- 401-1 - 401-n, 501-1 - 501-2, 601, 701: first landing pad
- 801, 901: first landing pad
- 1001, 1101, 1201, 1301: first landing pad
- 102, 202, 402: signal contacting area
- 103-1 - 103-2, 203-1 - 203-2: ground contacting area
- 403-1 - 403-2: ground contacting area
- 104, 204, 304, 404, 504-1 - 504-n: power meter interface
- 704, 804, 904, 1004, 1104: power meter interface

- 206-1 - 206-n, 506-1 - 506-8: second landing pad
- 606-1 - 606-7: second landing pad
- 207-1 - 207-n, 507-1 - 507-8: calibration standard
- 607-1 - 607-5, 1007-1 - 1007-3: calibration standard
- 1107-1 - 1107-4: calibration standard

- 308: trace
- 309, 609, 909, 1009, 1109, 1209: carrier substrate
- 1309-1, 1309-2: carrier substrate
- 310,910, 1010, 1110, 1210, 1310: housing base

- 412, 612, 712, 812: power measurement unit

- 513, 713, 813: measurement application system

- 714, 814: switching unit
- 715: signal output port
- 716: power meter output port
- 717, 817, 1517: signal measurement device

- 818: signal output interface
- 920: transmission line
- 921: inner conductor
- 922: housing cover

- 1225, 1325: waveguide
- 1227, 1327: trace

- 1328: bond wires

- 1599: wafer prober
- 98, 598-1, 598-2, 1598-1, 1598-2: probe
- 1597: chuck
- 1596: wafer
- 1595: integrated circuit

- 580: wafer
- 581-1 - 581-n: integrated circuit

- S1 - S5: method step

## Claims

1. Power calibration adapter (100, 200, 300, 400, 500, 600, 700, 800, 900, 1000, 1100,1200, 1300) for wafer probers (1599), the power calibration adapter (100, 200, 300, 400, 500, 600, 700, 800, 900, 1000, 1100,1200, 1300) comprising:
at least one first landing pad (101-1 - 101 -n, 201-1 - 201 -n, 301, 401-1 - 401 -n, 501 - 1 - 501-2, 601, 701, 801, 901, 1001, 1101, 1201, 1301), for releasably contacting a wafer prober tip of the wafer prober (1599); and
a power meter interface (104, 204, 304, 404, 504-1 - 504-n, 704, 804, 904, 1004, 1104) for each one of the first landing pads (101-1 - 101-n, 201-1 - 201-n, 301, 401 - 1 - 401-n, 501-1 - 501-2, 601, 701, 801, 901, 1001, 1101, 1201, 1301) that is coupled to the at least one first landing pad (101-1 - 101 -n, 201-1 - 201 -n, 301, 401- 1 - 401-n, 501-1 - 501-2, 601, 701, 801, 901, 1001, 1101, 1201, 1301) and that is configured to couple the at least one first landing pad (101-1 - 101-n, 201-1 - 201-n, 301, 401-1 - 401-n, 501-1 - 501-2, 601, 701, 801, 901, 1001, 1101, 1201, 1301) to a power measurement device.

2. Power calibration adapter (100, 200, 300, 400, 500, 600, 700, 800, 900, 1000, 1100,1200, 1300) according to claim 1, further comprising at least one second landing pad (206-1 - 206-n, 506-1 - 506-8, 606-1 - 606-7) and a calibration standard (207-1 - 207-n, 507-1 - 507-8, 607-1 - 607-5, 1007-1 - 1007-3, ) coupled to each one of the second landing pads (206-1 - 206-n, 506-1 - 506-8, 606-1 - 606-7).

3. Power calibration adapter (100, 200, 300, 400, 500, 600, 700, 800, 900, 1000, 1100,1200, 1300) according to claim 2, wherein the calibration standard (207-1 - 207-n, 507-1 - 507-8, 607-1 - 607-5, 1007-1 - 1007-3, 1107-1 - 1107-4) comprises at least one of an open calibration standard, a short calibration standard, and a match calibration standard.

4. Power calibration adapter (100, 200, 300, 400, 500, 600, 700, 800, 900, 1000, 1100,1200, 1300) according to claim 2, comprising at least two of the second landing pads (206-1 - 206-n, 506-1 - 506-8, 606-1 - 606-7), wherein a single one of the calibration standards (207-1 - 207-n, 507-1 - 507-8, 607-1 - 607-5, 1007-1 - 1007-3, 1107-1 - 1107-4) is coupled to the at least two second landing pads (206-1 - 206-n, 506-1 - 506-8, 606-1 - 606-7), the calibration standard (207-1 - 207-n, 507-1 - 507-8, 607-1 - 607-5, 1007-1 - 1007-3, 1107-1 - 1107-4) comprising at least one of a through calibration standard, and a line calibration standard.

5. Power calibration adapter (100, 200, 300, 400, 500, 600, 700, 800, 900, 1000, 1100,1200, 1300) according to any one of the preceding claims, further comprising at least one carrier substrate (309, 909, 1009, 1109, 1209, 1309-1, 1309-2), wherein at least one first landing pad (101-1 - 101-n, 201-1 - 201-n, 301, 401-1 - 401-n, 501-1 - 501-2, 601, 701, 801, 901, 1001, 1101, 1201, 1301) is arranged on each one of the carrier substrates (309, 909, 1009, 1109, 1209, 1309-1, 1309-2).

6. Power calibration adapter (100, 200, 300, 400, 500, 600, 700, 800, 900, 1000, 1100,1200, 1300) according to claim 5, further comprising a housing base (310, 910, 1010, 1110, 1210, 1310), wherein the carrier substrate (309, 909, 1009, 1109, 1209, 1309-1, 1309-2) is arranged at least in part on the housing base (310, 910, 1010, 1110, 1210, 1310); and especially wherein the carrier substrate (309, 909, 1009, 1109, 1209, 1309-1, 1309-2) is fixed to the housing base (310, 910, 1010, 1110, 1210, 1310), especially by at least one of gluing, soldering, screwing, and clamping.

7. Power calibration adapter (100, 200, 300, 400, 500, 600, 700, 800, 900, 1000, 1100,1200, 1300) according to claim 6, wherein the carrier substrate (309, 909, 1009, 1109, 1209, 1309-1, 1309-2) is releasably arranged on the housing base (310, 910, 1010, 1110, 1210, 1310).

8. Power calibration adapter (100, 200, 300, 400, 500, 600, 700, 800, 900, 1000, 1100,1200, 1300) according to any one of the preceding claims, comprising a power measurement unit (412, 612, 712, 812) that is coupled to the at least one first landing pad (101-1 - 101-n, 201-1 - 201-n, 301, 401-1 - 401-n, 501-1 - 501-2, 601, 701, 801, 901, 1001, 1101, 1201, 1301).

9. Power calibration adapter (100, 200, 300, 400, 500, 600, 700, 800, 900, 1000, 1100,1200, 1300) according to claim 5 and any one of claims 6 to 8, wherein power measurement unit (412, 612, 712, 812) is formed on the carrier substrate (309, 909, 1009, 1109, 1209, 1309-1, 1309-2).

10. Power calibration adapter (100, 200, 300, 400, 500, 600, 700, 800, 900, 1000, 1100,1200, 1300) according to any one of the preceding claims, wherein the at least one power meter interface (104, 204, 304, 404, 504-1 - 504-n, 704, 804, 904, 1004, 1104) comprises a connector configured to couple to an external power measurement device.

11. Power calibration adapter (100, 200, 300, 400, 500, 600, 700, 800, 900, 1000, 1100,1200, 1300) according to any one of the preceding claims, further comprising a switching unit (714, 814) and a signal output interface (818) for at least one of the first landing pads (101-1 - 101-n, 201-1 - 201-n, 301, 401-1 - 401-n, 501-1 - 501-2, 601, 701, 801, 901, 1001, 1101, 1201, 1301), the switching unit (714, 814) being configured to controllably couple the respective one of the first landing pads (101-1 - 101-n, 201-1 - 201-n, 301, 401-1 -401-n, 501-1 - 501-2, 601, 701, 801, 901, 1001, 1101, 1201, 1301) to the respective power meter interface (104, 204, 304, 404, 504-1 - 504-n, 704, 804, 904, 1004, 1104) or to the respective signal output interface (818).

12. Power calibration adapter (100, 200, 300, 400, 500, 600, 700, 800, 900, 1000, 1100,1200, 1300) according to any one of the preceding claims 1 to 10, further comprising a switching unit (714, 814), a power meter output port (716) and a signal output port (715) for at least one of the power meter interfaces (104, 204, 304, 404, 504-1 - 504-n, 704, 804, 904, 1004, 1104), the switching unit (714, 814) being configured to controllably couple the respective one of the power meter interfaces (104, 204, 304, 404, 504-1 - 504-n, 704, 804, 904, 1004, 1104) to the respective signal output port (715) or the respective power meter output port (716).

13. Measurement application system (513, 713, 813), comprising:
a power calibration adapter (100, 200, 300, 400, 500, 600, 700, 800, 900, 1000, 1100,1200, 1300) according to any one of the preceding claims; and
a power measurement device coupled to at least one power meter interface (104, 204, 304, 404, 504-1 - 504-n, 704, 804, 904, 1004, 1104) of the power calibration adapter (100, 200, 300, 400, 500, 600, 700, 800, 900, 1000, 1100,1200, 1300), and configured to determine a signal power of a signal that is applied to a wafer prober tip of a wafer prober (1599) while the wafer prober tip is contacting a respective first landing pad (101-1 - 101-n, 201-1 - 201-n, 301, 401-1 - 401-n, 501-1 - 501-2, 601, 701, 801, 901, 1001, 1101, 1201, 1301) of the power calibration adapter (100, 200, 300, 400, 500, 600, 700, 800, 900, 1000, 1100,1200, 1300).

14. Method for calibrating a wafer prober (1599), the method comprising:
contacting with each one of at least one wafer prober tip of the wafer prober (1599) at least one second landing pad (206-1 - 206-n, 506-1 - 506-8, 606-1 - 606-7) of a power calibration adapter (100, 200, 300, 400, 500, 600, 700, 800, 900, 1000, 1100,1200, 1300);
determining calibration parameters of the at least one wafer prober tip while the wafer prober tip contacts the at least one second landing pad (206-1 - 206-n, 506-1 - 506-8, 606-1 - 606-7);
performing a 1-port calibration for the at least one wafer prober tip based on the determined calibration parameters;
contacting with the at least one wafer prober tip a first landing pad (101-1 - 101-n, 201-1 - 201-n, 301, 401-1 - 401-n, 501-1 - 501-2, 601, 701, 801, 901, 1001, 1101, 1201, 1301); and
performing a power calibration for the at least one wafer prober tip.

15. Method according to claim 14, wherein the 1-port calibration and the power calibration are corrected with correction parameters of the power calibration adapter (100, 200, 300, 400, 500, 600, 700, 800, 900, 1000, 1100,1200, 1300), especially a reflection characteristic and/or a transmission characteristic of the power calibration adapter (100, 200, 300, 400, 500, 600, 700, 800, 900, 1000, 1100,1200, 1300).
